# EUROPÄISCHE PATENTSCHRIFT

(11) **EP 0 982 978 B1**
(45) Veröffentlichungstag und Bekanntmachung des Hinweises auf die Patenterteilung: **25.05.2005**
(21) Anmeldenummer: 99111300.2
(22) Anmeldetag: 10.06.1999
(51) Int. Cl.: H05K 3/34, H01R 12/04

(54) **Gehäuse, insbesondere Schlossgehäuse mit elektrischen Anschlusseinrichtungen**
Housing, in particular lock housing with electrical interconnections
Boîtier, en particulier boîtier de serrure avec interconnections électriques

(30) Priorität: 25.08.1998 DE 19838554; 15.04.1999 DE 19916949
(43) Veröffentlichungstag der Anmeldung: 01.03.2000
(73) Patentinhaber: Kiekert Aktiengesellschaft, 42579 Heiligenhaus (DE)
(72) Erfinder: Hülsmann, Thomas, 42555 Velbert (DE); Nass, Ulrich Dr., 45475 Mülheim (DE)
(74) Vertreter: Honke, Manfred, Dr.-Ing.

(56) Entgegenhaltungen:
- DE-A- 4 306 143
- DE-U- 29 608 233
- US-A- 3 805 117
- US-A- 4 665 614
- US-A- 4 978 307
- US-A- 5 198 391
- US-A- 5 399 108

## Beschreibung

Die Erfindung betrifft ein Gehäuse, insbesondere Schloßgehäuse für einen Kraftfahrzeugtürverschluß, Getriebegehäuse oder dergleichen Leitungsträger, aus Kunststoff, insbesondere Spritzguß-Kunststoff, mit einem oder mehreren elektrischen Bauteilen, denen elektrische Leitungen mit Anschlußeinrichtungen zugeordnet sind, wobei die elektrischen Leitungen mit dem Gehäuse fest verbunden sind, wie aus dem Dokument DE-A-4 306 143 bekannt ist.

Es ist ein Verfahren zur Herstellung eines aus Spritzguß-Kunststoff bestehenden Gehäuses für einen Kraftfahrzeugtürverschluß der eingangs beschriebenen Ausführungsformen bekannt, wonach die elektrischen Leitungen und die Kontaktvorrichtungen in eine dem herzustellenden Schloßgehäuse entsprechende Spritzgießform eingelegt und im Wege des Spritzgießens in zu armierende Bereiche des Gehäuses eingebettet werden, während die Kontaktvorrichtungen beim Spritzen des Schloßgehäuses zumindest bereichsweise in das Gehäuse eingespritzt werden. Dadurch wird das Schloßgehäuse bewehrt. Die eingebetteten Leitungen bestehen regelmäßig aus einem galvanisch leitenden Kunststoff oder einer galvanisch leitenden Kunststoffschicht und sind mit einer entsprechenden metallisch leitenden Auflage versehen. Die Anschlußeinrichtungen sind bei der bekannten Ausführungsform entweder als Löthülsen oder als federnde Lippen aufweisende Taschen ausgebildet.

Der Erfindung liegt die Aufgabe zugrunde, ein Gehäuse der eingangs beschriebenen Ausführungsform zu schaffen, das nicht nur in montagetechnischer und stabilitätsmäßiger Hinsicht allen Anforderungen genügt und einen einwandfreien elektrischen Kontakt gewährleistet, sondern bei dem auch auftretende Federkräfte nicht oder zumindest möglichst gering auf die elektrischen Bauteile übertragen werden.

Zur Lösung dieser Aufgabe lehrt die Erfindung, daß die an die elektrischen Leitungen anzuschließenden Bauteile einen oder mehrere federnde Anschlußleiter zur Kontaktierung mit den Anschlußeinrichtungen der elektrischen Leitungen aufweisen. Außerdem ist vorgesehen, daß die federnden Anschlußleiter der elektrischen Bauteile derart ausgebildet sind, daß die Federwirkung der Anschlußleiter in etwa orthogonal zur Fügerichtung der elektrischen Bauteile ausgerichtet ist. Fügerichtung meint im Rahmen der Erfindung die Richtung, in welcher die elektrischen Bauteile in das Gehäuse, z. B. Schloßgehäuse eingesetzt werden. Werden die Bauteile z. B. auf die Stirnwand des Schloßgehäuses aufgesetzt, so steht die Fügerichtung senkrecht zur Stirnwand. Die Erfindung geht zunächst von der Erkenntnis aus, daß Kontaktprobleme zwischen elektrischen Bauteilen und elektrischen Leitungen durch Verformungen oder sonstiger Veränderungen des metallisierbaren Kunststoffes nicht länger zu befürchten sind, wenn die Anschlußleiter der elektrischen Bauteile federnd ausgebildet sind. Denn dann können die Anschlußeinrichtungen der elektrischen Leitungen im Schloßgehäuse als gleichsam starre Anschlußeinrichtungen ausgebildet sein, so daß Verformungen unproblematisch sind. Im Ergebnis läßt sich das Gehäuse besonders einfach fertigen, weil die Elemente mit Federwirkung nicht mehr im Bereich der Anschlußeinrichtungen (also im Gehäuse), sondern im Bereich der Anschlußleiter der elektrischen Bauteile untergebracht sind. Dennoch sind Beschädigungen der elektrischen Bauteile nicht zu befürchten, weil die auftretenden Kräfte nicht oder nur unwesentlich auf den Vergußbereich und das Innere der elektrischen Bauteile übertragen werden. Der Anschlußleiter wird zwar beim Fügen kurzfristig belastet, anschließend werden die Belastungen aber weitestgehend unterdrückt, weil die Federwirkung der Anschlußleiter in etwa senkrecht zur Fügerichtung der elektrischen Bauteile ausgerichtet ist. Handelt es sich bei den elektrischen Bauteilen z. B. um Mikro-Schalter, so besteht nicht länger die Gefahr, daß die empfindlichen Schaltwerke der Mikro-Schalter beschädigt werden. Dieses gelingt bei einfacher Montage und bei gleichzeitig einwandfreier Kontaktierung.

Weitere erfindungswesentliche Maßnahmen sind im folgenden aufgeführt. So ist vorgesehen, daß die federnden Anschlußleiter streifenförmig, z. B. als Leiterblechstreifen, ausgebildet sind und in etwa orthogonal zur Fügerichtung aus dem elektrischen Bauteil austreten. Weiter ist vorgesehen, daß die Anschlußeinrichtungen der elektrischen Leitungen als senkrecht aufstehende Kontaktstege ausgebildet sind, die zumindest bereichsweise eine elektrisch leitende Beschichtung aufweisen oder aus einem elektrisch leitenden Material bestehen und daß die elektrischen Anschlußleiter als Spreizelemente mit Spreizflächen ausgebildet sind. Im Ergebnis lassen sich die elektrischen Bauteile auf einfache Weise in das Gehäuse einsetzen, wobei die als Spreizelemente ausgebildeten Anschlußleiter auf die Kontaktstege aufgesteckt werden. Dabei kann jeder elektrischen Leitung ein einziger Kontaktsteg zugeordnet sein, der z. B. fluchtend an die Leitung anschließt. Es ist aber auch möglich, daß mehrere elektrische Leitungen in einem gemeinsamen Kontaktsteg enden, der den einzelnen Leitungen zugeordnete elektrisch leitende Bereiche aufweist, die wiederum durch Isolierbereiche voneinander getrennt sind. In weiterer Ausgestaltung weisen die federnden Anschlußleiter ein in etwa parallel zur Fügerichtung abgewinkeltes Kontaktende auf, welches eine auffedernde Klemmausnehmung aufweist, die auf die Kontaktstege aufsteckbar ist. Die. Kontaktausnehmung kann dabei tulpenförmig, glockenförmig oder Omega-förmig ausgebildet sein. Diese Ausführungsformen zeichnen sich durch ihren einfachen Aufbau und ein hohes Maß an Stabilität aus.

In einer anderen Ausführungsform sind die federnden Anschlußleiter als U-förmig oder Omega-förmig gebogene Anschlußstreifen mit in Fügerichtung geöffnetem Klemmbereich ausgebildet. Dabei umfaßt der Anschlußstreifen den Kontaktsteg mit seinem zentralen Klemm- bzw. Kontaktbereich. Folglich lassen sich die federnden Anschlußleiter durch einfaches Biegen der Blechstreifen erzeugen. Eine weitere Bearbeitung, z. B. durch Stanzen oder Schneiden, ist nicht erforderlich.

Nach einem weiteren Vorschlag der Erfindung sind die Anschlußeinrichtungen der elektrischen Leitungen als rinnenförmige oder topfförmige Leiteraufnahmen ausgebildet. Die federnden Anschlußleiter sind dann als U-förmig oder Omega-förmig gebogene Anschlußstreifen mit sich in Fügerichtung schließendem Klemmbereich ausgebildet. Bei dieser Ausführungsform werden die Anschlußleiter in die Anschlußeinrichtungen eingesteckt.

Die Anschlußeinrichtungen können auch als senkrecht aufstehende Dorne ausgebildet sein, wobei die federnden Anschlußleitungen mit zur Fügerichtung orthogonaler Federwirkung im Bereich von parallel zur Fügerichtung verlaufenden Kontaktausnehmungen in den elektrischen Bauteilen angeordnet sind. Schließlich ist vorgesehen, daß für die federnden Anschlußleiter eine Abstützung an dem anzuschließenden Bauteil vorgesehen ist. Dabei kann es sich z. B. um eine angeformte Abstützung handeln. Dieses hat insbesondere den Vorteil, daß die im Zuge des Fügens auftretenden Belastungen der Bauteile von der Abstützung aufgenommen werden.

Im folgenden wird die Erfindung anhand einer lediglich ein Ausführungsbeispiel darstellenden Zeichnungen näher erläutert. Es zeigen:

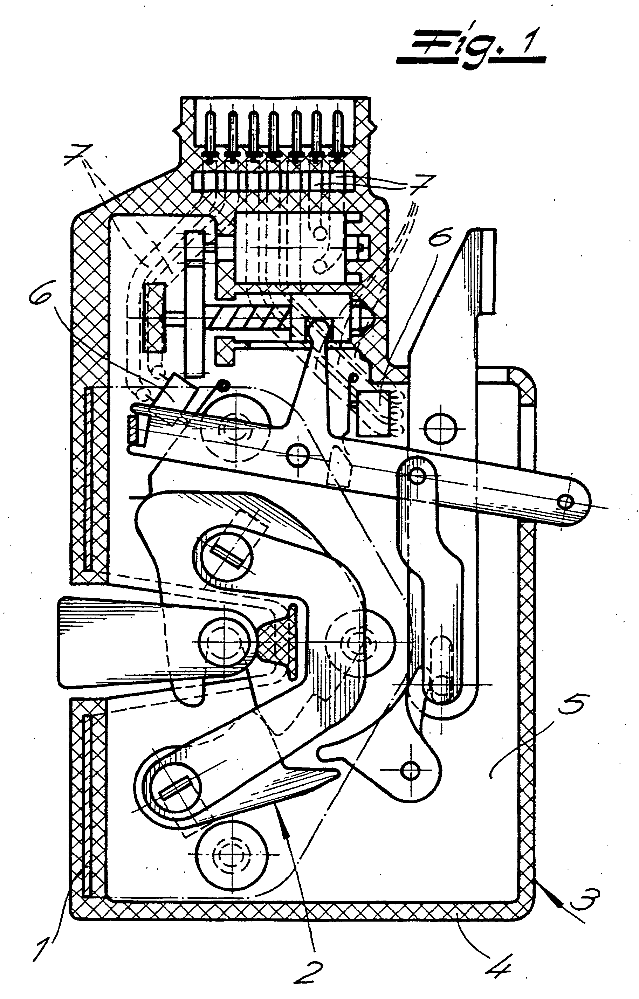

- **Fig. 1**: einen schematischen Vertikalschnitt durch einen Kraftfahrzeugtürverschluß mit einem Schloßgehäuse aus Kunststoff,
- **Fig. 2**: einen Teil des Schloßgehäuses mit Anschlußeinrichtungen und einen Mikro-Schalter als elektrisch anzuschließendes Bauteil in perspektivischer Darstellung,
- **Fig. 3**: eine abgewandelte Ausführungsform des Gegenstandes nach Fig. 2,
- **Fig. 4**: eine abgewandelte Ausführungsform des Gegenstandes nach Fig. 3 im Querschnitt,
- **Fig. 5**: eine weitere Ausführungsform des Gegenstandes nach Fig. 2,
- **Fig. 6**: einen Schnitt in Richtung C-C durch den Gegenstand nach Fig. 5,
- **Fig. 7**: den Gegenstand nach Fig. 5 in einer Draufsicht,
- **Fig. 8**: eine weitere Ausführungsform des Gegenstandes nach Fig. 2,
- **Fig. 9**: den Gegenstand nach Fig. 8 in der Draufsicht und montiertem Zustand,
- **Fig. 10**: in schematischer Darstellung einen Ausschnitt aus einer Gehäusewand mit einer von der einen Gehäuseseite auf die andere Gehäuseseite geführten Leiterbahn,
- **Fig. 11**: einen federnden Anschlußleiter in abgewandelter Ausführungsform und Stirnansicht,
- **Fig. 12**: den Gegenstand nach Fig. 11 in perspektivischer Darstellung und
- **Fig. 13**: eine abgewandelte Ausführungsform den Gegenstandes nach Fig. 6 mit dem Anschlußleiter nach den Fig. 11 und 12.

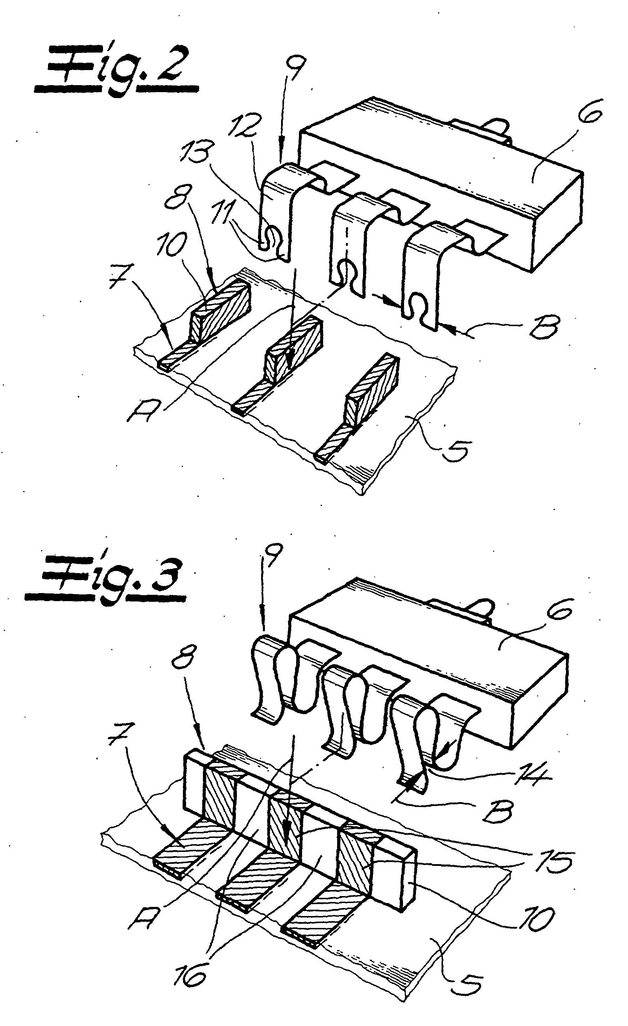

Der in den Figuren dargestellte Kraftfahrzeugtürverschluß besitzt ein Schloßblech 1, an dem Schloßblech 1 in einem Halterungsbereich befestigte oder gelagerte Bauteile 2 der Schließmechanik, und ein Schloßgehäuse 3 mit Gehäuseboden 4 und Stirnwand 5. Im übrigen sind elektrische Bauteile 6 vorgesehen, die über elektrische Leitungen 7 mit Anschlußeinrichtungen 8 zur Integration in elektrische Kreise verbunden sind. Diese elektrischen Bauteile 6 sind ihrerseits mit Anschlußleitern 9 für die Anschlußeinrichtungen 8 versehen. Dieses ist beispielsweise den Fig. 2 und 3, die unterschiedliche Ausführungsformen des Schloßgehäuses zeigen, zu entnehmen. Dabei sind die elektrischen Bauteile im abgebildeten Zustand noch nicht an die Anschlußeinrichtungen angeschlossen. Im einzelnen weisen die an die elektrischen Leitungen 7 anzuschließenden elektrischen Bauteile 6 mehrere federnde Anschlußleiter 9 zur Kontaktierung mit den Anschlußeinrichtungen 8 der elektrischen Leitungen 7 auf. Dabei sind die federnden Anschlußleiter 9 der elektrischen Bauteile 6 derart ausgebildet, daß die Federwirkung der Anschlußleiter 9 in etwa orthogonal zur Fügerichtung der elektrischen Bauteile 6 ausgerichtet ist. Die Federwirkung der Anschlußleiter 9 ist in den Figuren durch die Pfeile B dargestellt, während die Fügerichtung durch den Pfeil A angedeutet ist. Bei den in den Fig. 2 bis 7 dargestellten Ausführungsbeispielen sind die federnden Anschlußleiter 9 streifenförmig als Leiterblechstreifen 9 ausgebildet. Die Leiterblechstreifen 9 treten in etwa orthogonal zur Fügerichtung aus den elektrischen Bauteilen 6 aus.

In Fig. 2 ist erkennbar, daß die Anschlußeinrichtungen 8 der elektrischen Leitungen 7 als senkrecht aufstehende Kontaktstege 10 ausgebildet sind. Die elektrischen Anschlußleiter 9 sind als Spreizelemente mit Kontaktflächen 11 ausgebildet, welche auf die Kontaktstege 10 aufsteckbar sind. Dabei weisen die federnden Anschlußleiter 9 jeweils ein in etwa parallel zur Fügerichtung abgewinkeltes Kontaktende 12 auf, welches eine auffedernde Klemmausnehmung 13 aufweist, die auf die Kontaktstege 10 aufsteckbar ist. Diese federnde Klemmausnehmung 13 ist im Ausführungsbeispiel nach Fig. 2 tulpenförmig ausgebildet.

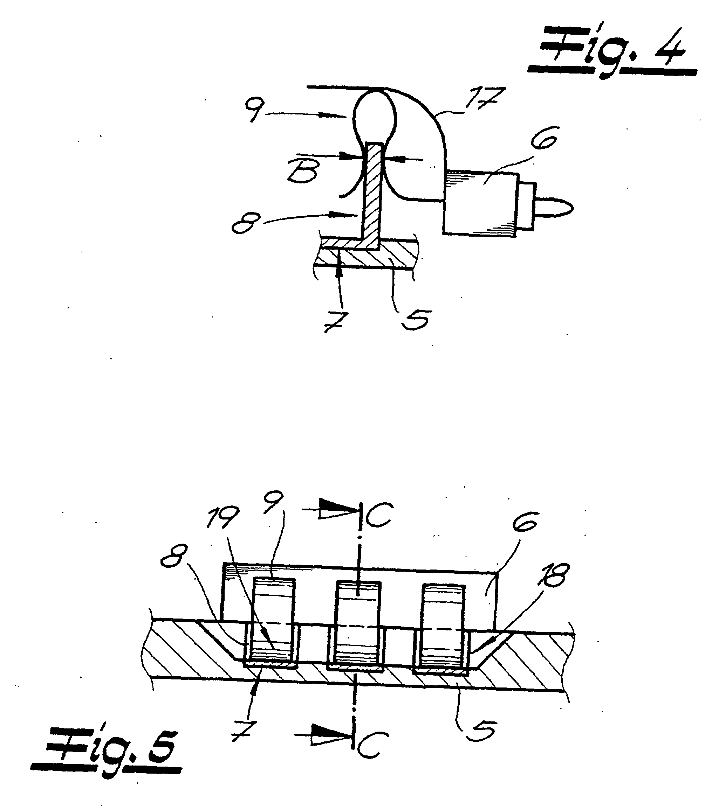

Im Ausführungsbeispiel nach Fig. 3 sind die federnden Anschlußleiter 9 als Omega-förmig gebogene Anschlußstreifen 9 mit in Fügerichtung geöffnetem Klemmbereich 14 ausgebildet. Die Anschlußeinrichtungen 8 der elektrischen Leitungen 7 sind wiederum als senkrecht aufstehender Kontaktsteg 10 ausgebildet. Während in dem Ausführungsbeispiel nach Fig. 2 jeder elektrischen Leitung 7 ein einziger Kontaktsteg 10 zugeordnet ist, ist bei dem Ausführungsbeispiel nach Fig. 3 ein gemeinsamer Kontaktsteg 10 vorgesehen, der den einzelnen Leitungen 7 zugeordnete elektrisch leitende Bereiche 15 aufweist. Diese elektrisch leitenden Bereiche 15 sind wiederum durch Isolierbereiche 16 voneinander getrennt. Fügerichtung und Richtung der Federwirkung sind wiederum durch die Pfeile A bzw. B angedeutet. Fig. 4 zeigt eine Ausführungsform bei der eine an dem anzuschließenden Bauteil 6 angeformte Abstützung 17 vorgesehen ist, die eine Belastung des Anschlußleiters im Zuge des Fügens verhindert oder zumindest vermindert. Im übrigen zeigt diese Figur den bereits montierten Zustand, bei welchem das elektrische Bauteil an die Anschlußeinrichtungen angeschlossen ist.

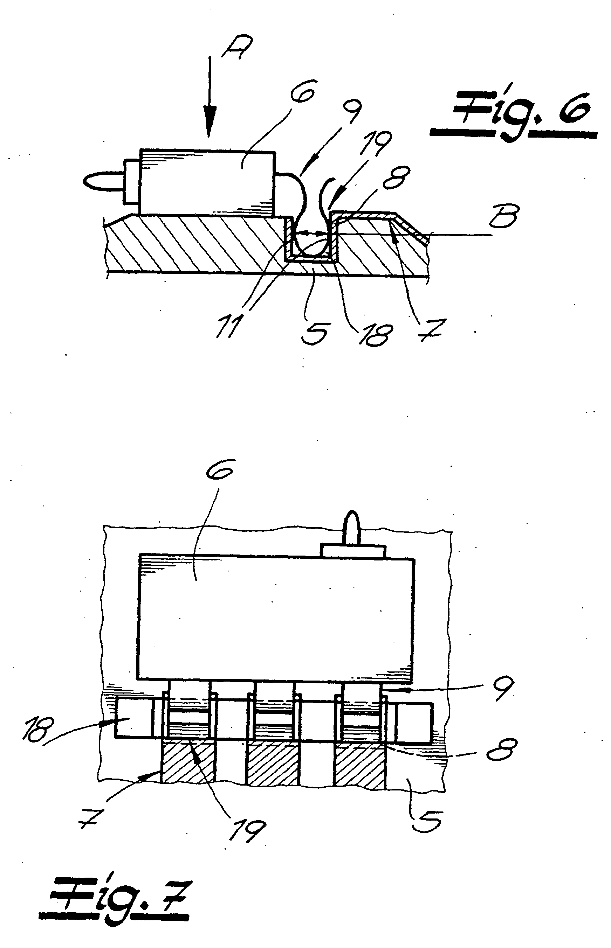

Fig. 5, 6 und 7 zeigen eine abgewandelte Ausführungsform der Erfindung. Auch hier ist der bereits montierte Zustand dargestellt. Die Anschlußeinrichtungen 8 der elektrischen Leitungen 7 sind als rinnenförmige Leitungsaufnahmen 18 ausgebildet. Die federnden Anschlußleiter 9 sind als Omega-förmig gebogene Anschlußstreifen mit sich in Fügerichtung schließendem Klemmbereich 19 ausgebildet, der in die Leitungsaufnahmen 18 einsteckbar ist. Während bei dem Ausführungsbeispiel nach Fig. 3 und 4 die Kontaktflächen 11 im Bereich der schmalsten Stelle des Omega-förmig gebogenen Anschlußstreifens angeordnet ist, befindet sich die Kontaktfläche 11 bei dem Ausführungsbeispiel nach Fig. 5 bis 7 im Bereich der breitesten Stelle des Anschlußstreifens. Dieses ist insbesondere Fig. 6 zu entnehmen.

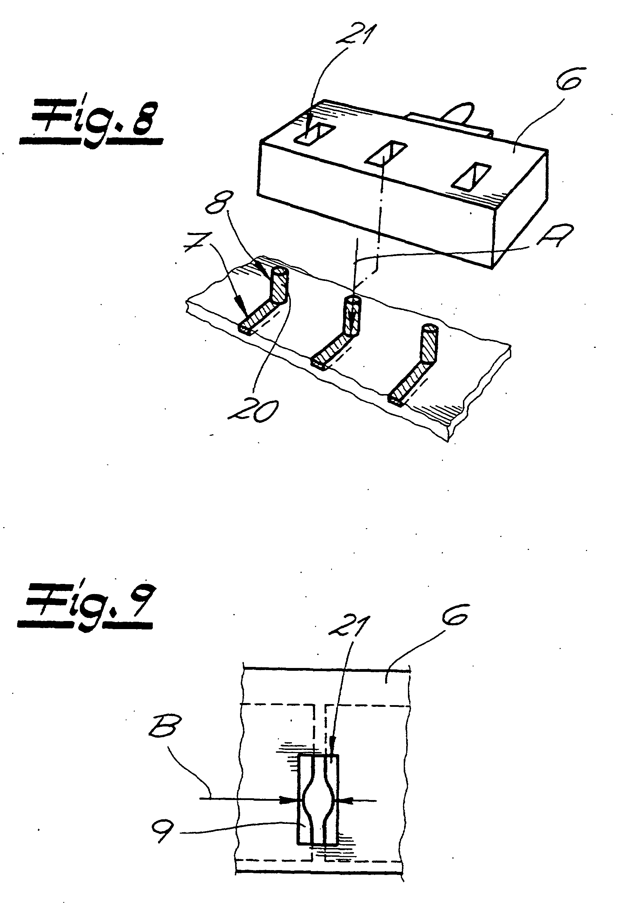

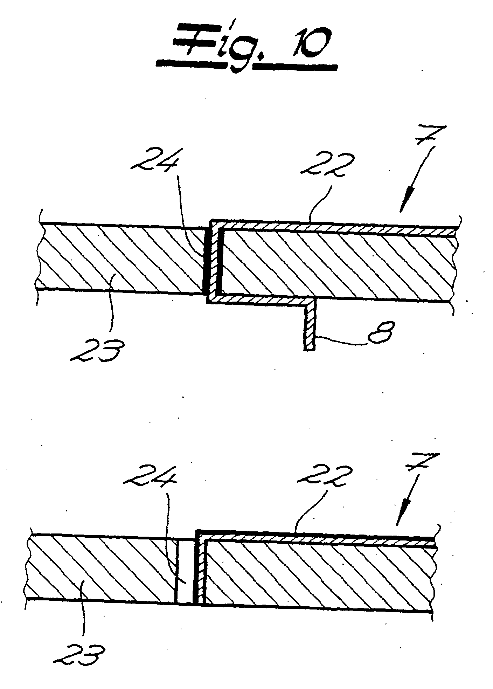

Die Fig. 8 und 9 zeigen ein Ausführungsbeispiel, bei welchem die Anschlußeinrichtungen 8 der elektrischen Leitungen 7 als senkrecht aufstehende Dorne 20 ausgebildet sind. Die federnden Anschlußleiter 9 sind im Bereich von parallel zur Fügerichtung verlaufenden Kontaktausnehmungen 21 in den elektrischen Bauteilen 6 angeordnet. Dieses ist insbesondere in Fig. 8 erkennbar. Fig. 9 verdeutlicht die zur Fügerichtung orthogonale Federwirkung der federnden Anschlußleiter. Diese ist wiederum durch die Pfeile B dargestellt.

Die elektrischen Leitungen 7 weisen Leiterbahnen 22 aus einem metallisierbaren Kunststoff auf, die auf der Gehäuseoberfläche verlaufen und adhäsiv mit dem Kunststoff des Gehäuses 23 verbunden, z. B. auf die Gehäuseoberfläche aufgespritzt sind. Die Leiterbahnen 22 können im Wege einer Galvanisierung metallisiert werden. Es besteht aber auch die Möglichkeit, die Leiterbahnen 22 mit einer leitenden metallischen Auflage zu belegen. Stetes kann es sich bei den Leiterbahnen 22 um den gleichen Kunststoff wie den Kunststoff des Gehäuses 23 handeln. Es kann aber auch ein anderer Kunststoff eingesetzt werden. Jedenfalls lassen sich die Leiterbahnen 22 in einem einzigen Werkzeug im Wege eines Zwei-Kammerverfahrens auf das Gehäuse 23 aufspritzen.

Im übrigen besteht die Möglichkeit, die Leiterbahnen 22 durch Durchbrechungen 24 in der Gehäusewand hindurch auf die andere Gehäuseseite zu führen. Das ist in Fig. 10 angedeutet. Die Durchbrechungen 24 werden abgedichtet und können im übrigen auch als Steckbuchsen ausgebildet sein, so daß die Abdichtung durch einen aufgesetzten Stecker erfolgt oder der Stecker eine entsprechende Dichtung aufweist.

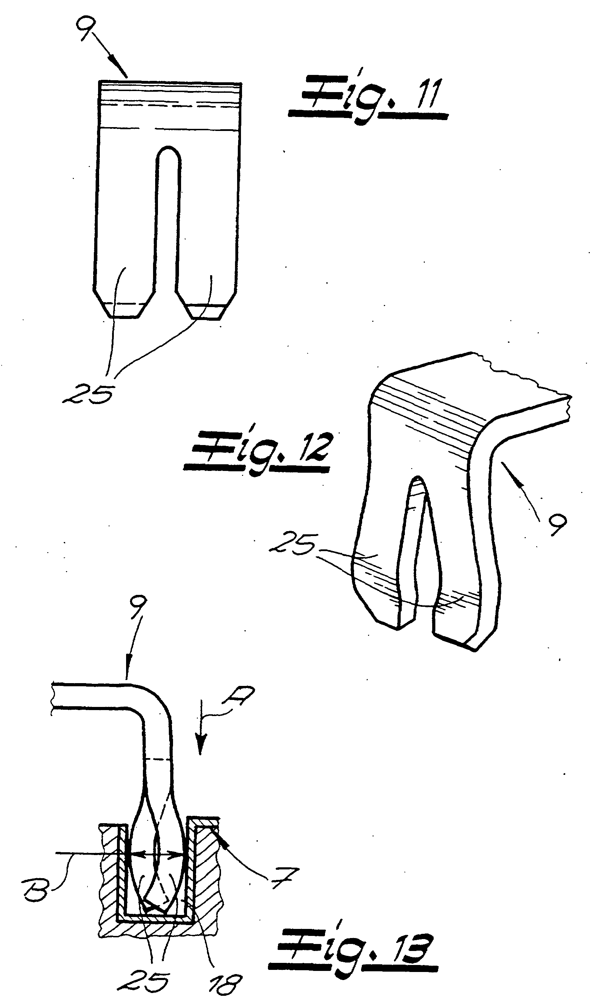

Nach der in den Fig. 11 bis 13 dargestellten Ausführungsform sind die federnden Anschlußleiter 9 als auseinanderspreizbare, z. B. in entgegengesetzte Richtung biegbare Kontaktlamellen 25 ausgebildet, die in die Leiteraufnahmen 18 mit Feder- und Kontaktwirkung einsetzbar sind. In diesem Fall wird eine verhältnismäßig kurze Anschlußfahne verwirklicht, die sich durch geringen Materialverbrauch und minimalen Verschnitt auszeichnet.

## Patentansprüche

1. Gehäuse, insbesondere Schloßgehäuse für einen Kraftfahrzeugtürverschluß, Getriebegehäuse oder dergleichen Leitungsträger, aus Kunststoff, insbesondere Spritzguß-Kunststoff, mit einem oder mehreren elektrischen Bauteilen, denen elektrische Leitungen mit Anschlußeinrichtungen zugeordnet sind, wobei die elektrischen Leitungen mit dem Gehäuse fest verbunden sind, **dadurch gekennzeichnet, daß** die an die elektrischen Leitungen (7) anzuschließenden Bauteile (6) einen oder mehrere federnde Anschlußleiter (9) zur Kontaktierung mit den Anschlußeinrichtungen (8) der elektrischen Leitungen (7) aufweisen.

2. Gehäuse nach Anspruch 1, **dadurch gekennzeichnet, daß** die federnden Anschlußleiter (9) der elektrischen Bauteile (6) derart ausgebildet sind, daß die Federwirkung der Anschlußleiter (9) in etwa orthogonal zur Fügerichtung der elektrischen Bauteile (6) ausgerichtet ist.

3. Gehäuse nach Anspruch 1 oder 2, **dadurch gekennzeichnet, daß** die federnden Anschlußleiter (9) streifenförmig, z. B. als Leiterblechstreifen (9) ausgebildet sind und in etwa orthogonal zur Fügerichtung aus dem elektrischen Bauteil (6) austreten.

4. Gehäuse nach einem der Ansprüche 1 bis 3, **dadurch gekennzeichnet, daß** die Anschlußeinrichtungen (8) der elektrischen Leitungen (7) als senkrecht aufstehende Kontaktstege (10) ausgebildet sind und daß die elektrischen Anschlußleiter (9) als Spreizelemente mit Kontaktflächen (11) ausgebildet sind, welche auf die Kontaktstege (10) aufsteckbar sind.

5. Gehäuse nach Anspruch 4, **dadurch gekennzeichnet, daß** die federnden Anschlußleiter (9) ein in etwa parallel zur Fügerichtung abgewinkeltes Kontaktende (12) aufweisen, welches eine auffedernde Klemmausnehmung (13) aufweist, die auf die Kontaktstege (10) aufsteckbar ist.

6. Gehäuse nach Anspruch 5, **dadurch gekennzeichnet, daß** die federnde Klemmausnehmung (13) tulpenförmig, glockenförmig oder Omega-förmig ausgebildet ist.

7. Gehäuse nach Anspruch 4, **dadurch gekennzeichnet, daß** die federnden Anschlußleiter (9) als U-förmig oder Omega-förmig gebogene Anschlußstreifen, mit in Fügerichtung geöffnetem Klemmbereich (14) ausgebildet sind.

8. Gehäuse nach einem der Ansprüche 1 bis 3, **dadurch gekennzeichnet, daß** die Anschlußeinrichtungen (8) der elektrischen Leitungen (7) als rinnenförmige oder topfförmige Leiteraufnahmen (18) ausgebildet sind.

9. Gehäuse nach einem einer Ansprüche 1 bis 3 oder 8, **dadurch gekennzeichnet, daß** die federnden Anschlußleiter (9) als U-förmig oder Omega-förmig gebogene Anschlußstreifen mit sich in Fügerichtung schliessendem Klemmbereich (19) ausgebildet sind, der in die Leiteraufnahmen (18) einsteckbar ist.

10. Gehäuse nach einem der Ansprüche 1 bis 3 oder 8, **dadurch gekennzeichnet, daß** die federnden Anschlußleiter (9) als auseinanderspreizbare, z. B. in entgegengesetzte Richtung biegbare Kontaktlamellen (25) ausgebildet sind, die in die Leiteraufnahmen (18) mit Federwirkung einsetzbar sind.

11. Gehäuse nach Anspruch 1 oder 2, **dadurch gekennzeichnet, daß** die Anschlußeinrichtungen (8) der elektrischen Leitungen (7) als senkrecht aufstehende Dorne (20) ausgebildet sind und daß die federnden Anschlußleiter (9) mit zur Fügerichtung orthogonaler Federwirkung im Bereich von parallel zur Fügerichtung verlaufenden Kontaktausnehmungen (21) in den elektrischen Bauteilen (6) angeordnet sind.

12. Gehäuse nach einem der Ansprüche 1 bis 11, **dadurch gekennzeichnet, daß** für den oder die federnden Anschlußleiter (9) eine Abstützung (17) an dem anzuschließenden Bauteil (6), z. B. eine angeformte Abstützung (17), vorgesehen ist.

13. Gehäuse nach einem der Ansprüche 1 bis 12, **dadurch gekennzeichnet, daß** die elektrischen Leitungen (7) Leiterbahnen (22) aus einem metallisierbaren Kunststoff aufweisen, die auf der Gehäuseoberfläche verlaufen und adhäsiv mit dem Kunststoff des Gehäuses (23) verbunden, z. B. auf die Gehäuseoberfläche aufgespritzt sind.

14. Gehäuse nach einem der Ansprüche 1 bis 13, **dadurch gekennzeichnet, daß** die Leiterbahnen (22) im Wege einer Galvanisierung metallisierbar sind.

15. Gehäuse nach einem der Ansprüche 1 bis 14, **dadurch gekennzeichnet, daß** die Leiterbahnen (22) mit einer leitenden Metallauflage belegbar sind.

16. Gehäuse nach einem der Ansprüche 1 bis 15, **dadurch gekennzeichnet, daß** die Leiterbahnen (22) durch Durchbrechungen (24) in der Gehäusewand hindurch auf die andere Gehäuseseite führbar sind.

## Claims

1. A housing, especially a lock housing for a motor vehicle door lock, gear housing or similar lead carrier, made of plastic, especially injection-moulded plastic, comprising one or a plurality of electrical components to which electrical leads with connecting devices are allocated, wherein the electrical leads are fixedly connected to the housing, **characterised in that** the components (6) connected to the electrical leads (7) have one or a plurality of spring connecting conductors (9) for contact with the connection devices (8) of the electrical leads (7).

2. The housing according to claim 1, **characterised in that** the spring connecting conductors (9) of the electrical components (6) are constructed such that the spring action of the connecting conductors (9) is aligned approximately orthogonally to the direction of joining of the electrical components (6).

3. The housing according to claim 1 or 2, **characterised in that** the spring connecting conductors (9) are constructed as strip-shaped, e.g. as conducting sheet-metal strips (9) and emerge from the electrical component (6) approximately orthogonally to the direction of joining.

4. The housing according to any one of claims 1 to 3, **characterised in that** the connecting devices (8) of the electrical leads (7) are constructed as perpendicularly standing contact cross-pieces (10) and that the electrical connecting conductors (9) are constructed as spreading elements with contact surfaces (11) which can be positioned on the contact cross-pieces (10).

5. The housing according to claim 4, **characterised in that** the spring connecting conductors (9) have a contact end (12) bent approximately parallel to the direction of joining, which has an outward-curling clamping recess (13) which can be positioned on the contact cross-piece (10).

6. The housing according to claim 5, **characterised in that** the spring clamp recess (13) is constructed as tulip-shaped, bell-shaped or omega-shaped.

7. The housing according to claim 4, **characterised in that** the spring connecting conductors (9) are constructed as U-shaped or omega-shaped curved connecting strips with a clamping region (14) which is open in the direction of joining.

8. The housing according to any one of claims 1 to 3, **characterised in that** the connecting devices (8) of the electrical leads (7) are constructed as groove-shaped or cup-shaped conductor receivers (18).

9. The housing according to any one of claims 1 to 3 or 8, **characterised in that** the spring connecting conductors (9) are constructed as U-shaped or omega-shaped curved connecting strips with a clamping region (19) which closes in the direction of joining, which can be inserted into the conductor receivers (18).

10. The housing according to any one of claims 1 to 3 or 8, **characterised in that** the spring connecting conductors (9) are constructed as contact lamellae (25) which can be spread apart e.g. which can be bent in opposing directions, which can be inserted into the conductor receivers (18) with a spring effect.

11. The housing according to claim 1 or 2, **characterised in that** the connecting devices (8) of the electrical leads (7) are constructed as perpendicularly standing pins (20)and that the spring connecting conductors (9) are arranged in the area of contact recesses (21) in the electrical components (6) running parallel to the direction of joining, with a spring effect orthogonal to the direction of joining.

12. The housing according to any one of claims 1 to 11, **characterised in that** a support (17) is provided on the component (6) to be connected, e.g. a moulded-on support (17), for the spring connecting conductor or conductors (9).

13. The housing according to any one of claims 1 to 12, **characterised in that** the electrical leads (7) have conductor paths (22) made of a metallisable plastic which run on the housing surface and are adhesively connected to the plastic of the housing (23), e.g. are sprayed onto the surface of the housing.

14. The housing according to any one of claims 1 to 13, **characterised in that** the conductor paths (22) can be metallised by way of electroplating.

15. The housing according to any one of claims 1 to 14, **characterised in that** the conductor paths (22) can be coated with a conducting metal layer.

16. The housing according to any one of claims 1 to 15, **characterised in that** the conductor paths (22) can be guided through gaps (24) in the housing wall onto the other side of the housing.

## Revendications

1. Boîtier, en particulier boîtier de serrure pour une serrure de porte de véhicule, boîtier de transmission ou porte-conducteurs similaire, en matière plastique, en particulier en matière plastique moulée par injection, avec un ou plusieurs composants électriques auxquels sont associées des lignes électriques avec des dispositifs de raccordement, les lignes électriques étant reliées de manière fixe au boîtier, **caractérisé en ce que** les composants (6) à raccorder aux lignes électriques (7) comportent un ou plusieurs conducteurs de raccordement (9) élastiques pour la mise en contact avec les dispositifs de raccordement (8) des lignes électriques (7).

2. Boîtier selon la revendication 1, **caractérisé en ce que** les conducteurs de raccordement (9) élastiques des composants électriques (6) sont conçus de manière que l'effet de ressort des conducteurs de raccordement (9) soit orienté à peu près orthogonalement à la direction d'assemblage des composants électriques (6).

3. Boîtier selon la revendication 1 ou 2, **caractérisé en ce que** les conducteurs de raccordement (9) élastiques sont réalisés en forme de bande, par exemple en tant que bandes conductrices en tôle (9) et ressortent du composant électrique (6) approximativement orthogonalement à la direction d'assemblage.

4. Boîtier selon l'une des revendications 1 à 3, **caractérisé en ce que** les dispositifs de raccordement (8) des lignes électriques (7) sont réalisés comme nervures de contact (10) se tenant verticalement et **en ce que** les conducteurs de raccordement électriques (9) sont réalisés comme éléments d'écartement avec des surfaces de contact (11) qui peuvent être enfichées sur les nervures de contact (10).

5. Boîtier selon la revendication 4, **caractérisé en ce que** les conducteurs de raccordement (9) élastiques présentent une extrémité de contact (12) coudée à peu près parallèlement à la direction d'assemblage, laquelle présente un évidement de serrage (13) faisant ressort qui peut être enfiché sur les nervures de contact (10).

6. Boîtier selon la revendication 5, **caractérisé en ce que** l'évidement de serrage (13) élastique est réalisé en forme de tulipe, de cloche ou d'oméga.

7. Boîtier selon la revendication 4, **caractérisé en ce que** les conducteurs de raccordement (9) élastiques sont réalisés comme bandes de raccordement courbées en U ou en oméga avec une zone de serrage (14) ouverte dans la direction d'assemblage.

8. Boîtier selon l'une des revendications 1 à 3, **caractérisé en ce que** les dispositifs de raccordement (8) des lignes électriques (7) sont réalisés comme logements pour conducteurs (18) en forme de rigole ou en forme de pot.

9. Boîtier selon l'une des revendications 1 à 3 ou 8, **caractérisé en ce que** les conducteurs de raccordement (9) élastiques sont réalisés comme bandes de raccordement courbées en U ou en oméga avec une zone de serrage (19) se fermant dans la direction d'assemblage et qui peut être enfichée dans les logements pour conducteurs (18).

10. Boîtier selon l'une des revendications 1 à 3 ou 8, **caractérisé en ce que** les conducteurs de raccordement (9) élastiques sont réalisés comme lamelles de contact (25) pouvant s'écarter les unes des autres, pouvant par exemple plier dans des sens opposés, qui peuvent être insérées avec effet de ressort dans les logements pour conducteurs (18).

11. Boîtier selon la revendication 1 ou 2, **caractérisé en ce que** les dispositifs de raccordement (8) des lignes électriques (7) sont réalisés comme broches (20) se tenant verticalement et **en ce que** les conducteurs de raccordement (9) élastiques sont disposés dans les composants électriques (6) avec effet de ressort orthogonal à la direction d'assemblage, dans la zone d'évidements de contact (21) s'étendant parallèlement à la direction d'assemblage.

12. Boîtier selon l'une des revendications 1 à 11, **caractérisé en ce que** pour le ou les conducteurs de raccordement (9) élastiques il est prévu un appui (17) sur le composant (6) à raccorder, par exemple un appui (17) venu de moulage.

13. Boîtier selon l'une des revendications 1 à 12, **caractérisé en ce que** les lignes électriques (7) comportent des pistes conductrices (22) en une matière plastique métallisable, qui s'étendent à la surface du boîtier et sont assemblées par adhésion à la matière plastique du boîtier (23), par exemple injectées sur la surface du boîtier.

14. Boîtier selon l'une des revendications 1 à 13, **caractérisé en ce que** les pistes conductrices (22) peuvent être métallisées au cours d'une galvanisation.

15. Boîtier selon l'une des revendications 1 à 14, **caractérisé en ce que** les pistes conductrices (22) peuvent être garnies d'un revêtement métallique conducteur.

16. Boîtier selon l'une des revendications 1 à 15, **caractérisé en ce que** les pistes conductrices (22) peuvent être guidées à travers des ajours (24) de la paroi du boîtier, jusque sur l'autre face du boîtier.
